# FASCICULE DE BREVET EUROPEEN

(11) **EP 3 728 163 B1**
(45) Date de publication et mention de la délivrance du brevet: **19.10.2022**
(21) Numéro de dépôt: 18826739.7
(22) Date de dépôt: 21.12.2018
(51) Int. Cl.: C04B 35/583, C04B 35/632, C04B 35/634, C09K 5/04, F28D 20/02, C04B 41/82, C04B 41/84, C04B 41/89, C04B 41/45, C09K 5/06, H01L 23/373, H01L 23/427

(54) **MATERIAU THERMIQUE AMELIORE A HAUTE CAPACITE ET HAUTE CONDUCTIVITE, SON PROCEDE DE PREPARATION ET COMPOSANTS LE COMPRENANT**
VERBESSERTES WÄRMEMATERIAL MIT HOHER KAPAZITÄT UND HOHER LEITFÄHIGKEIT, VERFAHREN ZUR HERSTELLUNG DAVON UND KOMPONENTEN DAMIT
ENHANCED THERMAL MATERIAL WITH HIGH CAPACITY AND HIGH CONDUCTIVTY, MANUFACTURING PROCESS THEREOF, AND PARTS COMPRISING IT

(30) Priorité: 22.12.2017 FR 1701357; 16.05.2018 WO PCT/EP2018/062780
(43) Date de publication de la demande: 28.10.2020
(73) Titulaire: THALES, 92400 Courbevoie (FR); Centre National de la Recherche Scientifique, 75016 Paris (FR); Université de Lille, 59000 Lille (FR); Nanyang Technological University, Singapore 639798 (SG)
(72) Inventeur: PAWLIK, Matthieu, Singapore 648558 (SG); TEO, Edwin, Hang, Tong, Singapore 791448 (SG); COQUET, Philippe, Singapore 259829 (SG)
(74) Mandataire: Lavoix
(86) Numéro de dépôt international: PCT/EP2018/086774
(87) Numéro de publication internationale: WO 2019/122419

(56) Documents cités:
- EP-A2- 1 333 710
- WO-A1-2017/161993
- US-A1- 2011 083 826
- JIE YANG ET AL: "An ice-templated assembly strategy to construct graphene oxide/boron nitride hybrid porous scaffolds in phase change materials with enhanced thermal conductivity and shape stability for light-thermal-electric energy conversion", JOURNAL OF MATERIALS CHEMISTRY A, vol. 4, no. 48, 1 janvier 2016 (2016-01-01), pages 18841-18851, XP055499904, GB ISSN: 2050-7488, DOI: 10.1039/C6TA08454K
- MANUELA LOEBLEIN ET AL: "Configurable Three-Dimensional Boron Nitride-Carbon Architecture and Its Tunable Electronic Behavior with Stable Thermal Performances", SMALL, vol. 10, no. 15, 1 août 2014 (2014-08-01), pages 2992-2999, XP055414175, DE ISSN: 1613-6810, DOI: 10.1002/smll.201400292 cité dans la demande
- WEIDONG LIANG ET AL: "Graphene-nickel/ n -carboxylic acids composites as form-stable phase change materials for thermal energy storage", SOLAR ENERGY MATERIALS AND SOLAR CELLS., vol. 132, 15 octobre 2014 (2014-10-15), pages 425-430, XP055499914, NL ISSN: 0927-0248, DOI: 10.1016/j.solmat.2014.09.032
- M. LOEBLEIN ET AL: "A "hairy" polymer/3D-foam hybrid for flexible high performance thermal gap filling applications in harsh environments", RSC ADVANCES, vol. 7, no. 62, 1 janvier 2017 (2017-01-01), pages 39292-39298, XP055443482, DOI: 10.1039/C7RA06297D

## Description

La présente invention concerne la gestion thermique, notamment pour les technologies qui requièrent une limitation de la montée en température, comme par exemple la régulation en température des composants électroniques. Celle-ci cherche à limiter efficacement l'augmentation de la température des composants pendant leur utilisation en fonctionnement transitoire, tout en occupant un espace minimal avec un poids réduit et sans court-circuiter les circuits.

La compacité grandissante de l'électronique rend la problématique de la gestion thermique de plus en plus cruciale. La miniaturisation de l'électronique demande aux techniques de gestion de la chaleur d'être compactes et peu couteuses en énergie. La problématique est donc de trouver un moyen de limiter l'élévation de température des composants pendant leur utilisation, afin de garantir leur fonctionnement optimal, et d'autre part de pouvoir stocker et restituer efficacement la chaleur, en particulier dans le cas d'environnements confinés. Ceci, sans endommager les composants, en limitant le poids final et en garantissant un encombrement minimum.

La solution la plus répandue pour le refroidissement est l'utilisation d'un puits thermique métallique massif mais celui-ci est en général encombrant et de masse non négligeable par rapport à celle de l'électronique. De plus sa capacité à évacuer la chaleur est limitée. Aussi, pour faciliter l'extraction de la chaleur, des matériaux d'interface thermique sont utilisés afin de réduire toutes résistances thermiques de contact entre la source de chaleur et le dissipateur. Ces matériaux sont en général des pâtes ou colles qui permettent une excellente conformité avec les composants. Toutefois, ceux-ci ne permettent pas de stocker la chaleur.

Enfin, une autre solution est l'utilisation de matériaux à changement de phase (MCP) permettant d'absorber et de stocker la chaleur pendant la période d'utilisation. En effet, ces matériaux ont la capacité de stocker la chaleur environnante grâce à leur enthalpie de fusion élevée (typiquement autour de 210 J/g), et en absorbant la chaleur ils limitent l'élévation de température de leur environnement. Les MCP sont des composants passifs mais ils possèdent une conductivité thermique faible (0.15-0.25 W/mK), et leur rigidité génère une résistance thermique de contact élevée qui limite leur capacité à absorber la chaleur.

Le premier point peut être amélioré en incorporant un matériau à forte conductivité thermique.

Les premières études pour tenter d'améliorer la conductivité thermique des MCP ont été réalisées dans les années 1980. Depuis plusieurs stratégies ont été mise en œuvre pour essayer d'augmenter leur conductivité thermique sans modifier leurs propriétés de stockage thermique. Ji et al. Energy Environ. Sci., vol. 7, no. 3, pp. 1185-1192, 2014 rapporte les différentes voies d'amélioration de la conductivité des MCP.

Deux stratégies sont exploitées pour améliorer la conductivité thermique des MCP. L'ajout d'additifs diffus, tel que des nanotubes de carbones, des feuilles de graphène, des fibres de carbone, permet une amélioration de la conductivité thermique avec un gain rapporté à la fraction volumique de l'additif inférieur à 2. Une meilleure continuité dans les matériaux conducteurs permet d'améliorer ce gain. Les premières études réalisées avec des mousses métalliques ont montré cet intérêt (Aluminium, Carbone, Nickel). Mais là encore, seul un gain maximum de 6 a pu être constaté.

Cependant, le graphite, ainsi que les mousses métalliques sont aussi d'excellents conducteurs électriques ce qui ne permet pas une application directe sur des composants électroniques : l'utilisation de ces matériaux sur des composants électriques pour la gestion thermique risquerait de court-circuiter les systèmes.

Il est donc nécessaire de développer un matériau composite alternatif, à base de MCP et d'un additif présentant une conductivité thermique élevée mais qui permet également de moduler sa conductivité électrique en rendant le composite partiellement conducteur ou isolant électriquement.

Le nitrure de bore (BN) sous forme de poudre a été proposé pour améliorer les propriétés thermiques des MCP. Le BN est un excellent isolant électrique tout en étant un excellent conducteur thermique. En le mélangeant avec un MCP, on augmente la conductivité thermique du MCP et donc sa capacité de stockage, tout en garantissant l'isolation électrique entre les composants. Il est aussi possible de doper ce BN avec du carbone (BN(C)) ce qui permet de le rendre plus ou moins conducteur d'électricité.

Le BN est capable de rivaliser avec les propriétés thermiques du graphène, tout en ayant de plus une résistance électrique très élevée. Sous sa forme 2D, le BN est un matériau inerte chimiquement, avec une stabilité thermique parfaite jusqu'à 1000°C. Sa conductivité thermique, bien que théoriquement inférieure au graphène, reste très élevée (de l'ordre de 2000 W/mK en théorie), comparée au cuivre (400 W/mK) classiquement utilisé.

Ainsi, Jeong et al (Int. J. Heat Mass Transf., vol. 71, pp. 245-250, 2014) ont décrit un remplissage de MCP par de la poudre de BN à 80% en MCP, soit une fraction en BN de 20%. Un gain en conductivité thermique de 477% par rapport à la conductivité thermique du MCP est décrit, ce qui correspond donc à un gain par fraction volumique du BN de 0.24 seulement.

La mousse de BN dopée au carbone (BNC) est connue (Loeblein et al, Small, vol.10, 15, 2992-2999, 2014) et a aussi montré sa conductivité thermique élevée, comparable au BN WO 2017/161993 A1 décrit un matériau composite comprenant une mousse céramique en BN imprégnée avec un polymère MCP (paraffine) et divulgue son utilisation du composite pour des composants électroniques. Sur la Figure 1 de ce document on voit des portions de mousse (zones foncées) dénuées de MCP (zone grisée) en surface, mais pas d'encapsulation dans un polymère protecteur.

La demande FR 17 00516, publiée sous le numéro FR 3 066 490, propose un composite amélioré permettant un gain accru de la conductivité thermique, comprenant une structure continue de BN(C) et un MCP incorporé au sein de de ladite structure. Néanmoins, lors du stockage d'énergie, le MCP peut changer de phase, et s'épancher par fusion, au sein de la structure de BN(C). Il reste donc à mettre à disposition un composite amélioré présentant des caractéristiques de conductivité thermique similaires mais dépourvu de cet inconvénient.

Ainsi, il est proposé selon l'invention un matériau composite comprenant :
- Du nitrure de bore (BN(C)) sous forme de structure continue (1);
- Une couche interne d'un matériau à changement de phase (MCP) (5) incorporé au sein de ladite structure continue de BN(C) (1) et
- Une portion superficielle (1') de BN(C) dénuée de MCP, sous chacune des faces externes inférieure et supérieure du matériau composite, d'épaisseur respective E1 et E2,
ledit matériau étant caractérisé en ce que :
la couche de MCP (5) est encapsulée par une couche d'enrobage de polymère (10) d'épaisseur E', et lesdites portions superficielles (1') dénuées de MCP sont situées chacune de part et d'autre de la couche interne de MCP encapsulée (10).

### Le polymère d'encapsulation

Selon un mode de réalisation, ledit polymère d'encapsulation présente généralement une température de fusion inférieure à la température de fusion du MCP, et peut être aisément solidifié (polymérisé ), par exemple au moyen d'un agent de solidification (précurseur), de sorte que le polymère, une fois sous forme solide, soit stable à haute température, notamment à la température de changement de phase du MCP.

Ainsi, le terme « polymère » utilisé ainsi vise également les mélanges dudit polymère et d'un agent de solidification.

Avantageusement, on peut choisir le polymère de sorte qu'il soit sous forme liquide à température ambiante de façon à pouvoir infuser au sein de la structure continue de BN(C) sans chauffage, puis qu'il soit solidifié/polymérisé après l'imprégnation désirée. Généralement, le polymère est isolant électrique et thermique.

L'enrobage du MCP permet ainsi de contenir au sein d'une capsule de polymère solide le MCP, y compris lors du changement de phase éventuel du MCP en phase liquide. La capsule de polymère permet ainsi d'éviter les fuites de MCP lorsqu'il est sous forme liquide, au sein de la structure de BN(C).

Selon un mode de réalisation, ledit polymère peut être le polydiméthylsiloxane (PDMS) et ses dérivés. Typiquement, on peut utiliser le PDMS qui est liquide à température ambiante et peut être solidifié/polymérisé à 80°C en présence d'un agent de solidification/précurseur. Il est alors stable aux températures de fusion du MCP.

Dans le cas du PDMS, on peut avantageusement utiliser à titre d'agent de solidification/précurseur le copolymère de diméthyle méthylhydrogène siloxane.

La couche d'enrobage est constituée du polymère d'encapsulation lui-même imprégné au sein de la structure continue de BN(C) : la couche d'enrobage incorporant le BN(C) et le polymère d'encapsulation acquière donc de fait au moins partiellement les propriétés du BN(C). La couche d'enrobage présente donc une conductivité thermique supérieure à celle du polymère d'enrobage. De même, les propriétés électriques de la couche d'enrobage dépendent des propriétés électriques du BN(C) suivant que du carbone est présent ou non.

Le terme « encapsulé » utilisé ici fait référence à l'enrobage continu de la couche de MCP par le polymère, de façon à contenir le MCP dans ladite capsule ainsi formée et d'éviter les fuites de MCP au sein de la structure de BN(C). L'enrobage doit donc recouvrir l'ensemble du volume de MCP imprégné dans la structure de BN(C).

La couche d'enrobage fait référence à la couche de polymère solidifiée, imprégnée au sein de la structure continue de BN(C), autour de la couche de MCP.

Selon un mode de réalisation, la couche d'enrobage présente une épaisseur E' constante sur l'ensemble du volume de MCP ainsi recouvert.

Selon un autre mode de réalisation, la couche d'enrobage présente des épaisseurs Ei' identiques ou différentes sur chacune des faces i de la couche de MCP.

### La structure continue de BN(C)

La « structure continue de BN(C) » fait référence à tout matériau poreux constitué de BN, de structure 3D continue, non dispersée, éventuellement carbonée (i.e.) dopée par du carbone : elle est alors qualifiée ici de BNC. A titre de structure continue, on peut notamment citer les mousses, les grilles.

Les mousses de BN(C) et leur procédé de fabrication sont décrites par Loeblein et al, Small, vol.10, 15, 2992-2999, 2014.

Typiquement, la mousse de BN(C) peut être réalisée par croissance CVD sur un squelette métallique de cuivre ou de nickel. Après la croissance du BN(C), la mousse est enduite d'un polymère tel que le PMMA pour garantir sa stabilité puis, elle est plongée dans un bain d'acide pour retirer le squelette métallique. La mousse de BN seul, est obtenue en gravant le polymère.

La mousse de BN(C) peut être renforcée, par exemple en effectuant une croissance longue, ou plusieurs croissances pour augmenter l'épaisseur de BN(C) ou en conservant le PMMA sur la mousse (avec une épaisseur de PMMA suffisamment fine pour maintenir la conductivité thermique désirée, le PMMA ayant une conductivité thermique faible 0.2 W/mK), et/ou en ajoutant des additifs pour augmenter la conductivité thermique Généralement, la structure continue de BN(C) peut comprendre entre 5 et 80 % de carbone (en poids). Ce pourcentage dépend des applications envisagées. La teneur en carbone peut notamment être modulée de façon uniforme ou localement pour faire varier les propriétés électriques, par exemple augmenter la conductivité électrique sur l'ensemble de la structure ou sur certaines zones, typiquement dans des applications telles que la protection électromagnétique des composants électroniques.

Selon un mode de réalisation, la structure continue de BN(C) présente une densité comprise entre 1 et 5 mg/cm³, et une porosité comprise entre 5 et 120 pores par pouce. La conductivité thermique de la structure continue est généralement supérieure à la conductivité thermique du MCP.

La structure continue telle que la mousse de BN(C) étant flexible, elle peut s'adapter à la rugosité de surface du composant électronique et réduire la présence de poches d'air, réduisant ainsi la résistance thermique de contact. Elle peut aussi endurer les changements de phase du MCP qui a généralement une expansion de phase de 10 à 15%.

De plus, la structure continue telle que la mousse de BN(C) présente l'avantage d'avoir une densité extrêmement faible, ce qui permet de conserver la capacité de stockage du MCP à poids constant. Le BN(C) est un matériau inerte chimiquement, il permet donc de réaliser la passivation/protection des composants électroniques face à l'environnement. Ceci permet d'utiliser le composé directement sur l'électronique et d'améliorer l'absorption de la chaleur.

### Le MCP

On entend par MCP, tout matériau capable d'effectuer une transition de phase à une température (ou plage de température restreinte) et de stocker et éventuellement céder de l'énergie lors de cette transition. Lors de la transition de phase, la température du MCP reste constante. Généralement les MCP convenant à l'invention impliquent une transition de phase solide/solide ou solide/liquide.

Pour assurer un stockage thermique optimal, ils possèdent typiquement une densité d'énergie latente de fusion au moins égale à 50 J/g.

Selon un mode de réalisation, les MCP peuvent être choisis parmi les MCP de type polymères, organiques, organométalliques, inorganiques ou eutectiques.

A titre de MCP, on peut notamment citer les MCP choisis parmi les MCP commercialisés par RUBITHERM, le Polywax polyéthylène (commercialisé par Baker Hughes), le Puretemp (commercialisé par Puretemp), la paraffine, l'érythritol, le néopenthylglycol, le pentaérythritole.

Le choix du MCP dépend de la température maximale autorisée par l'utilisation considérée. On choisira typiquement un MCP dont la température de transition de phase est inférieure ou égale à la température maximale autorisée.

### Le matériau composite

Selon un mode de réalisation, le matériau composite présente une structure continue de BN(C), dont une portion superficielle inférieure et une portion superficielle supérieure de BN(C) sont chacune dénuées de MCP, et dont la zone interne située entre les deux zones superficielles est imprégnée de MCP et est encapsulée par un enrobage de polymère.

Le matériau composite selon l'invention est tel que le MCP et le polymère d'encapsulation sont incorporés dans les interstices, tel que les pores de ladite structure continue de BN(C), tel que, sous chacune des faces inférieure et supérieure, une portion d'épaisseur E1 et E2, respectivement, non nulle est dénuée de MCP. Le matériau possède donc au moins deux couches sous tout ou partie d'une de ses faces, qui sont dénuée de MCP.

Il est entendu que le matériau peut également comprendre des portions dénuées de MCP sous une ou plusieurs de ses faces latérales.

Le terme « face externe» s'entend comme une surface extérieure du matériau composite, destinée à être en contact avec l'élément à réguler thermiquement lorsque le matériau composite est appliqué. Il peut s'agir de face externe inférieure, supérieure ou de faces latérales.

La « portion superficielle » ou « portion » peut correspondre à tout ou partie de la face externe du composite, étant entendu que la portion comprend la partie de la face externe ainsi que la couche d'épaisseur E immédiatement située sous cette partie de la face. Dans cette portion, la structure continue est dénuée de MCP.

Le matériau composite comprend au moins deux portions superficielles (1') inférieure et supérieure, d'épaisseur E1 et E2 sous tout ou partie des faces inférieure et supérieure, telles qu'au sein desdites portions, la structure continue de BN(C) est dénuée de MCP.

Il est entendu que les épaisseurs E1 et E2 peuvent être identiques ou différentes.

Tel qu'utilisé ici, le terme « épaisseur E » fait référence à E1 et/ou E2. De même, le terme E' fait référence à E1' et/ou E2', le cas échéant.

Les épaisseurs E1 et E2 desdites portions superficielles sont substantiellement inférieures à l'épaisseur du composite. Typiquement, les épaisseurs E1 et E2 peuvent être adaptées en fonction de la rugosité du matériau sur lequel le matériau composite sera appliqué. Elles sont en général d'épaisseur au moins égale au diamètre d'un pore de la structure continue. Ces épaisseurs doivent être suffisantes pour minimiser la résistance de contact et réaliser la conduction thermique nécessaire. L'épaisseur de l'ensemble de la structure est généralement limitée en raison des impératifs de poids et d'encombrement des composants électrique. On peut par exemple citer des épaisseurs E1 et E2 supérieures à 250 µm, notamment pour une structure continue de très haute porosité.

Les épaisseurs E1 et E2 peuvent être contrôlées par le procédé de fabrication du matériau composite.

L'épaisseur E' de la couche d'enrobage (10) est généralement uniforme sur l'ensemble de la couche d'enrobage.

Alternativement, la couche d'enrobage (10) peut avoir des épaisseurs différentes E1' et E2', notamment sur les faces inférieures et supérieures de la couche interne de MCP (5). Typiquement, E' (respectivement E1' et E2') est inférieure aux épaisseurs E1 et E2. Elle peut être contrôlée par le procédé de fabrication de la couche d'enrobage.

Les portions superficielles de structure continue de BN(C) dénuées de MCP et de polymère d'encapsulation est donc uniquement constituée de structure continue de BN(C) qui permet d'assurer un bon contact avec l'électronique et ainsi de garantir une bonne conduction thermique du circuit vers le composite tout en contrôlant l'impact électrique du composite sur le reste du circuit.

Typiquement, le matériau composite selon l'invention présente donc notamment les avantages suivants :
- très bonne conformabilité avec la surface à réguler thermiquement
- versatilité : la température de changement de phase peut être modulée entre 50 et 200°C, en modifiant le MCP ;
- capacité de stockage thermique facilement élevée;
- conductivité thermique améliorée par rapport à celle du MCP (le gain rapporté à la fraction volumique en BN(C) peut atteindre 10) ;
- isolation électrique adaptable globalement ou spatialement, pour ne pas perturber les systèmes électroniques ;
- inerte et stable chimiquement, n'émettant pas de gaz en condition normale de fonctionnement, permettant d'éviter toutes réactions avec l'environnement ;
- de densité faible, permettant de limiter le poids du système ;
- de résistance thermique de contact faible, permettant d'assurer la bonne absorption de la chaleur du composant électrique.

Selon un autre objet, la présente invention concerne également le procédé de préparation dudit matériau composite.

Selon l'invention, le procédé comprend :
i. la formation d'une couche interne de MCP (5) au sein d'une structure continue de BN(C) (1) comprenant deux zones superficielles inférieure et supérieure (1") d'épaisseurs respectives E1" et E2" dénuées de MCP;
ii. l'encapsulation de la couche de MCP (5) par une couche d'enrobage polymérique (10) d'épaisseur E'.

Il résulte alors un composite selon l'invention tel que E1=E1"-E' et E2=E2"-E'.

### La formation de la couche interne de MCP (i)

La formation d'une couche interne de MCP (5) au sein de la structure continue de BN(C) (1) peut être réalisée par application du procédé décrit dans la demande FR 17 00516.

En particulier, ceci peut être effectué par infusion du MCP sous forme liquide dans une structure continue de BN(C), à l'exception de chaque portion superficielle (1") sous les faces externes inférieure et supérieure de ladite face de la structure continue de BN(C) dénuées de MCP.

Ces portions ont respectivement l'épaisseur E1" et E2".

Selon un premier mode de réalisation, la formation de la couche interne (5) comprend les étapes suivantes :
- La protection préalable de chaque portion superficielle sous les faces externes inférieure et supérieure de la structure continue de BN(C) sur une épaisseur E1" et E2", respectivement ;
- L'imprégnation de la structure continue de BN(C) par un MCP sous forme liquide ;
- La déprotection sélective des portions superficielles (1") protégées ;
d'où il résulte une structure continue de BN(C) dans laquelle est incorporée une couche interne de MCP (5), à l'exception desdites portions superficielles (1") d'épaisseur E1" et E2", dénuées de MCP.

La protection peut être effectuée par imprégnation d'un matériau protecteur dans l'épaisseur de ladite portion superficielle.

Cette imprégnation peut être réalisée par toute méthode permettant d'appliquer en surface et dans l'épaisseur d'une matrice un matériau liquide. La méthode d'application dépend de la nature du matériau et de sa viscosité, et de la matrice.

Selon un mode de réalisation, l'imprégnation est réalisée par infusion, à chaud. L'infusion peut être réalisée par dépôt ou trempage de chaque portion superficielle de la structure continue de BN(C) à protéger, sur ou dans une solution du matériau protecteur, sur l'épaisseur de BN(C) désirée.

Généralement, cette imprégnation est réalisée à température supérieure à la température de fusion du matériau protecteur, de sorte qu'il soit sous forme liquide avec une viscosité adaptée à l'épaisseur désirée.

La température du matériau protecteur peut être maintenue à la température désirée en maintenant le bain de matériau protecteur sur une plaque chauffante.

Le matériau protecteur est choisi de telle façon qu'il puisse être :
- imprégné à l'état liquide,
- maintenu à l'état solide lors de l'imprégnation du MCP à l'état liquide, et
- déprotégé sélectivement du composite formé.

Typiquement, le matériau protecteur est un polymère, éventuellement dilué dans un solvant pour ajuster la viscosité du matériau protecteur à la nature de la structure continue de BN(C) et de l'épaisseur désirée.

Selon un mode de réalisation, le matériau protecteur peut être choisi notamment parmi le polyéthylèneoxyde (PEO) avec l'eau ou l'isopropanol (IPA) comme solvant, le polyfluorure de vinylidène (PVDF) avec le diméthylacétamide (DMA) ou le N,N-diméthylformamide (DMF) comme solvant, le néopentylglycol (NPG) avec l'eau comme solvant.

Selon un mode de réalisation, on utilise à titre de matériau protecteur le PEO, dilué dans l'eau, avec un taux de dilution compris entre 10 et 50%, notamment entre 20 et 25%.

Le PEO est un polymère très commun et qui ne pose pas de problème particulier en termes de manipulation et de stockage. Son solvant est l'eau, qui présente l'avantage d'un coût faible et d'une manipulation et stockage là encore aisée.

Selon un autre mode de réalisation, le matériau protecteur est le NPG, qui peut être imprégné à 130°C environ et peut être déprotégé par de l'éthanol concentré ou en solution diluée, à température comprise entre 50°C et 70°C;

Le matériau protecteur peut être dégazé préalablement à son utilisation, pour supprimer les bulles d'air et permettre ainsi une meilleure imprégnation.

Lorsque la protection est réalisée par un matériau protecteur à l'état liquide, le procédé comprend l'étape intermédiaire de fixation du matériau protecteur sur la structure continue, par augmentation de la viscosité du matériau protecteur, par exemple par évaporation du solvant par exemple.

L'étape de protection peut être réalisée autant de fois que nécessaire en fonction du nombre de portions superficielles à protéger, avant l'étape d'imprégnation du MCP.

L'imprégnation de la structure continue de BN(C) par le MCP est ensuite réalisée avec un MCP liquide, après protection de la ou des portions superficielles à protéger. Classiquement, l'étape d'imprégnation est conduite à une température supérieure à la température de fusion du MCP.

Typiquement, le matériau protecteur doit posséder soit une température de fusion supérieure à la température de fusion du MCP, soit si le matériau protecteur a une température de fusion inférieure, avoir une durée de fusion lorsqu'il est plongé dans le MCP liquide, très supérieure au temps d'infusion du MCP dans la structure continue non protégée. De plus, typiquement, le matériau protecteur ne doit pas être attaqué chimiquement par le MCP sous forme liquide.

Au besoin, il est possible de refroidir localement les portions superficielles avec le matériau protecteur pendant l'imprégnation du MCP.

L'imprégnation du MCP peut être réalisée par trempage de la totalité de la structure continue protégée dans une solution de MCP.

Généralement, le procédé comprend en outre l'étape intermédiaire de fixation du MCP sur la structure continue, par diminution de la température pour faire passer le MCP à l'état solide, préalablement à l'étape de déprotection. Cette étape peut être réalisée dans des moules de formes variées pour s'adapter au packaging et à l'application.

La déprotection peut être effectuée notamment par dégradation sélective du matériau protecteur, par exemple par voie chimique, typiquement par action d'un solvant de déprotection dans lequel le matériau protecteur est soluble. Ceci peut être réalisé par trempage de la totalité de la structure continue protégée dans un bain du solvant considéré.

A titre de solvant de déprotection, on peut citer les solvants des matériaux protecteurs cités plus hauts.

Dans le cas du NPG, cela peut être typiquement réalisé dans un bain d'éthanol à 60°C permettant d'obtenir ladite portion superficielle. La température du bain peut être adaptée afin d'obtenir une vitesse de gravure plus ou moins rapide.

Cette alternative du procédé selon l'invention permet avantageusement de préparer un composite de type « sandwich », présentant pour deux de ses faces opposées des portions de BN(C) dénuées de MCP, comme décrit plus haut selon un premier mode de réalisation.

Selon un deuxième mode de réalisation, le procédé comprend le retrait de MCP imprégné dans la structure de BN(C) au sein de la ou des portions superficielles.

A la différence du premier procédé, ce mode de réalisation ne nécessite pas d'étape de protection de ladite portion superficielle.

Ainsi, le procédé selon ce deuxième mode de réalisation comprend les étapes suivantes :
- L'imprégnation de la structure continue de BN(C) (1) par un MCP (5) sous forme liquide ;
   - - La gravure sélective du MCP au sein d'une ou plusieurs portions superficielles.

Tel qu'utilisé ici, le terme « gravure » désigne la gravure chimique, qui peut être réalisée par immersion dans un bain de solvant de gravure. Le solvant de gravure est un solvant permettant de dissoudre le MCP et qui n'endommage pas la structure continue de BN(C) pendant la gravure.

On peut ainsi citer l'éthanol, l'isopropanol (IPA), l'acétone, le toluène, le xylène, l'huile végétale à titre de solvant de gravure.

La température de la solution de gravure permet de contrôler la vitesse de gravure. En effet, plus la température va être élevée plus la vitesse de gravure va être rapide. Le bain contient généralement suffisamment de solvant pour éviter la saturation du solvant en MCP et ainsi éviter les re-dépots de MCP.

La gravure est typiquement conduite à une température inférieure à la température d'ébullition du bain et également inférieure à celle de fusion du MCP, pour éviter une liquéfaction du MCP.

Typiquement, dans le cas d'utilisation d'éthanol avec un MCP ayant une température de fusion de 90°C, la température de gravure se situe entre 50 et 80°C suivant la vitesse de gravure désirée

L'arrêt de la gravure peut être effectué en retirant le composite du bain de gravure.

A l'issue de la gravure, on peut effectuer une étape de rinçage, généralement réalisée en trempant le composite dans un ou plusieurs bains d'éthanol à la même température que le bain de gravure.

Puis un séchage peut être réalisé, par exemple sur plaque chauffante ou encore dans un four à une température inférieure à la température de fusion du MCP.

Cette alternative du procédé de l'invention permet avantageusement de préparer un composite présentant sous toutes ses faces des portions dénuées de MCP.

Selon un troisième mode de réalisation, le procédé combine au moins une étape de protection et au moins une étape de gravure du MCP. Ce mode de réalisation permet de réaliser des portions superficielles d'épaisseurs différentes.

Le procédé comprend alors les étapes suivantes :
- La protection préalable d'au moins une portion superficielle (1') de la structure continue de BN(C) (1) par un matériau protecteur ayant une vitesse de gravure différente que celle du MCP ;
- L'imprégnation de la structure continue de BN(C) (1) par un MCP (5) sous forme liquide ;
- La gravure du MCP et du matériau protecteur par immersion du matériau dans un solvant de gravure.

L'anisotropie de la gravure peut être contrôlée en utilisant un matériau protecteur avec une vitesse de gravure différente de celle du MCP pour le bain chimique de gravure utilisé. Par exemple, préalablement à l'étape d'infusion du MCP dans la structure continue de BN(C), une portion superficielle de la structure continue de BN(C) peut être infusée par un matériau protecteur, typiquement du NPG à l'état liquide à une température supérieure à la température de fusion du MCP. Après solidification du NPG, le MCP est infusé à l'état liquide à une température comprise entre la température de fusion du MCP et celle du NPG. Ensuite, le composite est gravé par la solution de gravure. Comme la vitesse de gravure du matériau protecteur est différente de celle du MCP, il en résulte une portion superficielle dénuée de MCP d'épaisseur différente suivant que la portion avait été imprégnée de matériau protecteur ou de MCP. Au besoin, la ou les portions comprenant encore du matériau protecteur peuvent être déprotégées comme explicité plus haut.

Avantageusement, le solvant de gravure du MCP permet également la déprotection/gravure du matériau protecteur.

Par exemple, pour un bain d'éthanol à 60°C la gravure du NPG est presque instantanée alors que celle du MCP est de l'ordre de 10 µm par minute. Toute la zone qui a été infusée par le NPG, qui peut être de plusieurs millimètres, est alors libérée sans que les zones non protégées aient pu être gravées de façon significative.

Le matériau ainsi formé par cette alternative présentent une structure continue de BN(C) dans laquelle est incorporée le MCP (5), à l'exception de ladite portion superficielle (1'), dénuée de MCP et des autres surfaces où le MCP a été gravé, étant entendu que des portions superficielles d'épaisseurs différentes peuvent être réalisées, suivant que les dites portions ont été protégées ou non.

Cette deuxième alternative de procédé selon l'invention permet avantageusement de préparer un composite selon le deuxième mode de réalisation décrit plus haut, présentant sous l'ensemble de ses faces inférieures, supérieures et latérales des portions superficielles de BN(C) dénuées de MCP, délimitant ainsi un volume intérieur constitué de BN(C) et de MCP.

Le procédé selon l'invention peut également comprendre à titre préalable la préparation de la structure continue de BN(C).

La mousse de BN(C) peut être préparée par application ou adaptation de la méthodologie décrite par Loeblein et al., Small, vol.10, n.15, 2992-2999, 2014.

Ainsi, la mousse de BN(C) peut être notamment préparée par croissance CVD (dépôt chimique en phase vapeur) sur un squelette métallique à base de cuivre ou de nickel par exemple. Après la croissance du BN(C), la mousse est enduite d'un polymère tel que le PMMA pour garantir sa stabilité, puis elle est plongée dans un bain d'acide pour retirer le squelette métallique. La mousse de BN(C) est ensuite obtenue en retirant le polymère ou, selon une variante, la PMMA peut être au moins partiellement conservé pour augmenter la solidité de la mousse.

Le matériau composite formé à l'issue de l'étape (i) comprend donc une couche interne de MPC (5) au sein d'une structure continue de BN(C) (1) et deux portions superficielles (1") inférieure et supérieure d'épaisseur E1" et E2", respectivement sous et sur cette couche de MCP.

### L'encapsulation (ii)

Typiquement, l'encapsulation ii) peut comprendre les étapes suivantes :
- La protection partielle de chaque portion superficielle (1") sous chaque face inférieure et supérieure d'un matériau composite obtenu à l'étape (i), sur une épaisseur E1 et E2 respectivement inférieure à E1" et E2", d'où il résulte deux portions superficielles (1');
- L'imprégnation du matériau composite ainsi protégé sur chacune de ces deux portions superficielles (1') par le polymère d'enrobage (10) sous forme liquide' ;
- La déprotection sélective des portions protégées (1');
formant ainsi une structure continue de BN(C) dans laquelle est incorporée une couche interne de MCP (5) encapsulée par un polymère (10) d'épaisseur E', ladite couche interne 5 encapsulée étant située entre deux portions superficielles (1') de BN(C) dénuées de MCP d'épaisseur E1 et E2.

Ainsi, le matériau composite formé comprend deux portions superficielles inférieure et supérieure d'épaisseur respective E1 et E2, telles que E1=E1"-E1' et E2"= E2'-E2. L'épaisseur E' de la couche d'enrobage est donc définie comme l'épaisseur de la portion d'épaisseur E1" (respectivement E2") non protégée par la couche de protection d'épaisseur E1 (respectivement E2).

Il est par ailleurs entendu que les épaisseurs E1, E1", E2, E2" peuvent être égales ou différentes.

La protection peut être effectuée par imprégnation d'un matériau protecteur sur une épaisseur partielle E1 et E2 dans chacune desdites portions superficielles (1") du matériau obtenu à l'étape (i).

Le matériau protecteur est imprégné sur une épaisseur E1 et E2 des portions (1") de BN(C), telle que E1 et E2 sont inférieures à E1" et E2", respectivement, définissant ainsi deux couches intermédiaires de BN(C) non protégées d'épaisseur E' (respectivement E'1 et E2'), respectivement situées entre la couche interne de MCP et les portions (1') inférieures et supérieures protégées.

Cette imprégnation et le choix du matériau protecteur peuvent être opérés comme discuté au paragraphe (i) ci-dessus.

A l'issue de la protection de chacune des portions superficielles (1'), le polymère d'encapsulation (10) est alors imprégné dans les portions (1') de BN(C) non protégées et dénuées de matériau protecteur et de MCP d'épaisseur E'.

Ceci peut être réalisé par trempage de la totalité de la structure continue protégée dans un bain du polymère d'encapsulation, en mélange avec un agent de solidification, sous forme liquide. Ceci peut avantageusement être effectué à température ambiante.

Un dégazage sous vide peut être effectué avant immersion et/ou lors de l'immersion de la structure dans le bain du polymère d'encapsulation afin d'éviter la présence de bulles dans le polymère d'encapsulation, lors de la solidification.

L'immersion peut être effectuée dans un moule à la taille du composite désiré ou dans tout autre récipient adapté.

Après imprégnation, la structure est extraite du bain et le polymère est généralement solidifié, par exemple par cuisson de la structure ou par exposition aux UV notamment. Dans le cas du PDMS, ceci peut généralement être effectué par recuit à environ 80°C, typiquement pendant une heure dans un four.

Si nécessaire, le matériau peut être taillé par découpe du polymère d'encapsulation pour supprimer les enrobages externes à la structure, notamment à la surface des faces inférieure et/ou supérieure et/ou pour dimensionner la couche d'enrobage sur les faces externes latérales, à l'épaisseur désirée.

Ainsi, la couche de polymère éventuellement formée sur les faces externes inférieure et supérieure doit être retirée pour laisser apparaitre les faces externes inférieure et extérieure imprégnées du matériau protecteur, afin de permettre la déprotection.

Cette étape de découpage est généralement nécessaire quand l'imprégnation dans le polymère n'est pas effectuée dans un moule à la taille.

La déprotection peut ensuite être effectuée par exemple par immersion de la totalité de la structure dans un bain de solvant de déprotection, sélectif pour le matériau protecteur, par application ou adaptation de la méthode de déprotection discutée au paragraphe (i) ci-dessus.

Le matériau composite ainsi formé peut être appliqué par exemple sur un composant électronique.

La présente invention concerne donc un composant à réguler thermiquement comprenant un composite selon l'invention, notamment tel que le composite est appliqué sur sa face dénuée de MCP en contact avec le composant.

Généralement, le choix du MCP est tel que la température de fusion du MCP est inférieure ou égale à la température maximale de fonctionnement du composant.

La mousse de BN(C) possède une conductivité thermique élevée et est flexible/conformable. En se compressant elle comble tous les trous d'air et réduit la résistance thermique de contact. Ceci permet d'améliorer la transmission de la chaleur du composant électronique vers le MCP. De plus, la continuité de la mousse permet de diffuser cette chaleur vers le MCP pour ensuite la stoker. Aussi, la variation de la quantité de carbone dans la mousse de BN(C) de façon globale ou localisée, permet de rendre celle-ci compatible avec l'électronique sur lequel elle est appliquée. Ceci permet de mettre le MCP au plus près des points chauds.

Selon un autre objet, la présente invention concerne également le procédé de fabrication d'un composant électronique comprenant un composite selon l'invention

Ceci peut être réalisée par toute méthode habituelle par exemple par compression du composite, par exemple par encapsulation du composite dans de l'aluminium ou un autre encapsulant non métallique.

L'invention et ses avantages seront mieux compris à l'étude de la description qui va suivre, donnée uniquement à titre d'exemple, et faite en référence aux dessins annexés, sur lesquels :
- les Figures 1 à 13 représentent des schémas illustratifs des étapes de fabrication d'un matériau composite selon l'invention ; et
- Les Figures 14 à 16 représentent des schémas illustratifs des étapes de fabrication d'un matériau composite selon l'invention relatives à la formation de la couche interne de MCP (5) au sein de la structure continue de BN(C) (1) dénuée de MCP dans les deux couches superficielles inférieure et supérieure, selon le deuxième mode de réalisation
- les Figures 17 et 18 représentent des schémas illustratifs des étapes de fabrication d'un composant électronique comprenant un matériau composite selon l'invention.

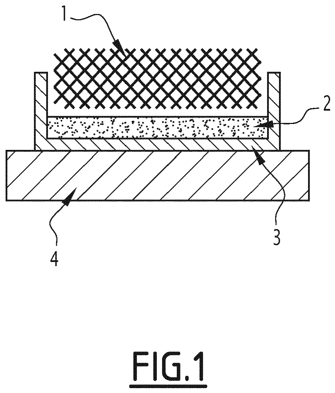

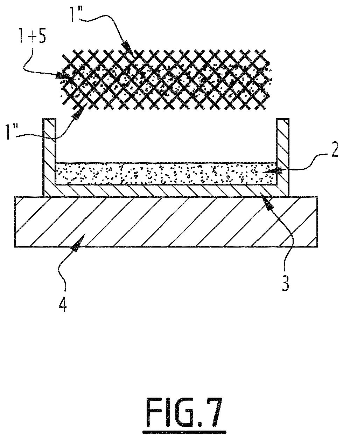

Comme illustré sur les Figures 1 à 3, selon un mode de réalisation, le matériau composite selon l'invention peut être préparé par formation d'une couche interne de MCP 5 au sein d'une structure continue de BN(C) 1 illustrée aux figures 1 à 6, puis par encapsulation de la couche interne de MCP 5, représentée schématiquement aux Figures 7 à 13.

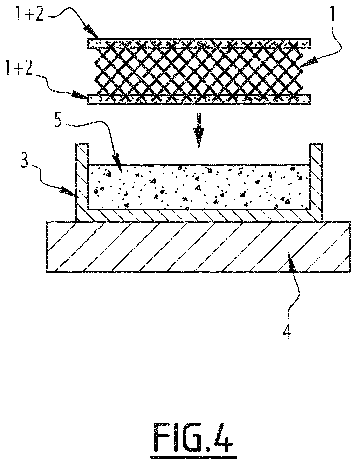

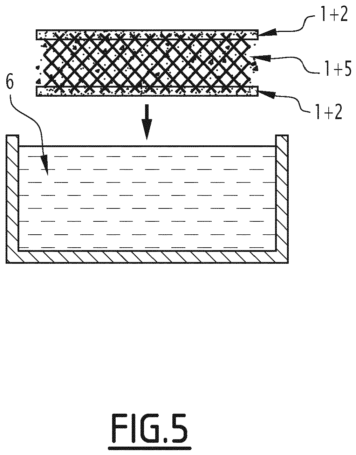

La fabrication du composite comprend la réalisation de la mousse de BN(C) 1, puis la protection de deux portions superficielles 1" inférieure et supérieure de la mousse 1 par un matériau protecteur 2 (Figures 1 à 3), afin d'éviter la présence de MCP 5 en surface, puis l'infusion du MCP 5 dans la mousse 1 (Figure 4) et finalement le retrait de la protection 2 (Figure 5) pour libérer la mousse des portions superficielles 1".

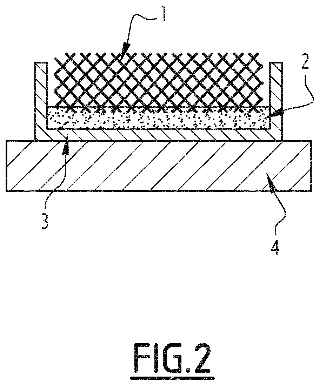

Plus précisément, comme illustré sur les Figures 1 et 2, un matériau protecteur 2 tel qu'un polymère en solution dans un solvant est préparé afin d'obtenir la viscosité voulue (qui influe sur les épaisseurs E1" et E2" des portions superficielles 1" de la mousse imprégnée par ledit matériau 2) et limiter la présence de bulles lors de sa solidification. En effet, les bulles rendraient le matériau 2 fragile par endroit et autoriseraient la pénétration du MCP 5 liquide. Cette viscosité dépend du polymère ainsi que de son taux de dilution dans un solvant.

Ensuite, le matériau protecteur 2 est déposé dans un récipient 3 (Figure 1) et une des faces inférieure ou supérieure de la mousse de BN(C) 1 est déposée sur ledit matériau 2 (Figure 2). Le tout est chauffé par exemple sur une plaque chauffante 4, jusqu'à ce que le matériau 2 forme une fine couche en surface de la mousse 1. L'épaisseur de la portion superficielle 1" protégée peut être contrôlée grâce à la viscosité du matériau 2.

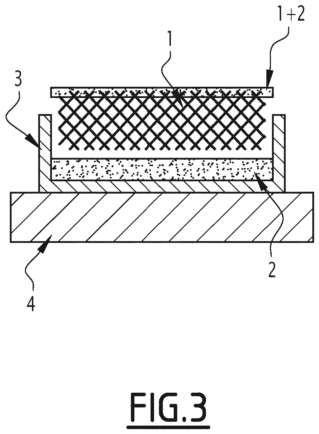

En option, et comme représentée à la Figure 3, cette opération peut être réalisée de la même façon sur l'autre face supérieure ou inférieure de la mousse de BN(C).

Comme illustré sur la Figure 4, une fois que chaque face sur laquelle on souhaite préserver une portion superficielle 1" dépourvue de MCP est protégée, le MCP 5 est chauffé pour passer à l'état liquide. La mousse 1 protégée est plongée dans un bain du MCP 5. On laisse le MCP 5 infuser seulement le cœur de la mousse 1 puis on laisse le tout refroidir pour que le MCP 5 passe à l'état solide.. On retire ensuite le composite du moule. La forme du moule pour le MCP est arbitrairement carrée sur les schémas, mais celle-ci peut être modifiée pour s'adapter aux contraintes du packaging et de l'application.

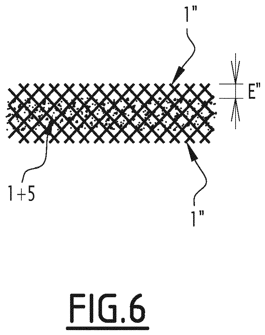

Enfin, comme illustré sur la Figure 6, on plonge le matériau composite dans un bain de solvant 6 du matériau protecteur 2, de façon à solubiliser le matériau 2, libérant ainsi chaque portion superficielle 1" d'épaisseur E1" et E2" du matériau 2, E1" et E2" pouvant être égales (soit E").

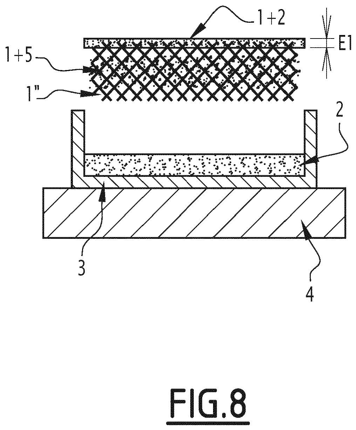

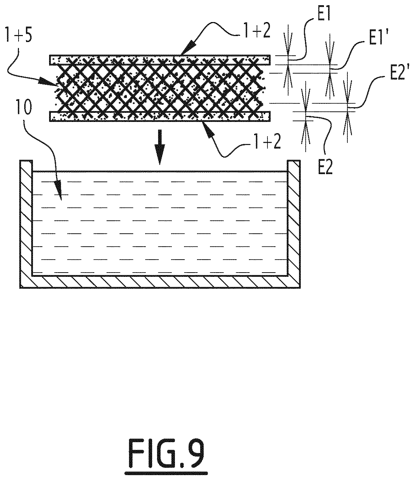

L'encapsulation de la couche interne de MCP 1 est ensuite réalisée. On immerge le matériau composite obtenu à la figure 6 dans un bain de matériau protecteur 2 maintenu sous forme liquide sur une plaque chauffante 4 (figure 7). Le matériau composite est immergé sur une épaisseur E1 de la face inférieure, puis il est extrait du bain et retourné et immergé sur une hauteur E2 de la face supérieure du matériau composite (figure 8). Après le retrait, on obtient donc un matériau composite constitué d'une structure continue de BNC, comprenant une couche interne de MCP 5, ainsi que deux portions externes inférieure et extérieure de BN(C) imprégnées de matériau protecteur 2, sur une épaisseur respective E1 et E2. De part et d'autre de la couche interne 5, sont situées deux couches de BN(C) dénuées de MCP et de matériau protecteur d'épaisseur respective E1' et E2', étant entendu que E1' et E2' peuvent être égales (soit E'). Le matériau composite ainsi protégé est alors imprégné du polymère d'encapsulation : ceci est réalisé par immersion de la structure complète au sein d'un bain dudit polymère 10 (figure 9). Le polymère d'encapsulation liquide infuse donc à l'intérieur de la structure de BN(C) libre, dans les épaisseurs E1' et E2' précitées.

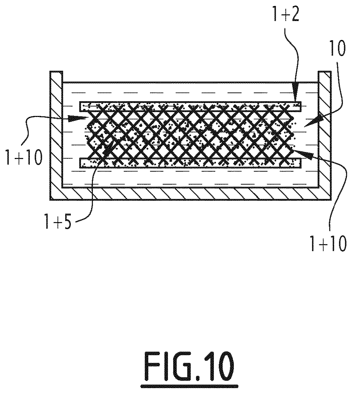

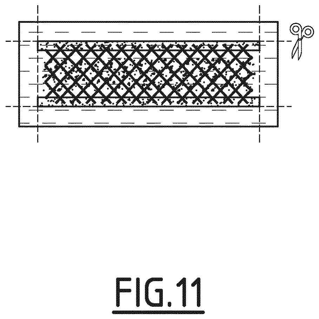

Puis le polymère est solidifié par exemple en plaçant l'ensemble bain et composite, dans un four (figure 10). A l'issue de la solidification, le matériau composite est alors généralement entouré sur l'ensemble des surfaces externes d'une couche de polymère d'encapsulation, notamment si la taille du moule est supérieure à la taille du composite. Il est donc généralement recommandé de découper la couche externe d'encapsulation qui peut exister sur les surfaces externes inférieure et supérieure, afin de dégager les portions superficielles protégées 1" (figure 11).

Sur les surfaces latérales, la couche de polymère doit être conservée sur chacune des faces latérales de MCP, de façon à encapsuler l'ensemble du volume le MCP. La figure 10 représente la solidification du polymère d'encapsulation au sein d'un récipient de taille substantiellement supérieure au matériau composite. En option, il est possible d'effectuer cette étape dans un moule correspondant à la taille du matériau composite, de façon à éviter la solidification du polymère d'encapsulation inutile, notamment sur les faces externes, inférieure et supérieure.

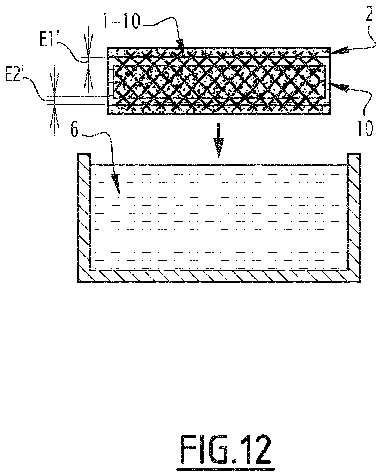

Les composites pour lesquels les faces externes inférieure et supérieure ont été mises à découvert peuvent être alors déprotégées (figure 12) en plongeant le matériau dans un bain de solvant du matériau protecteur 6.

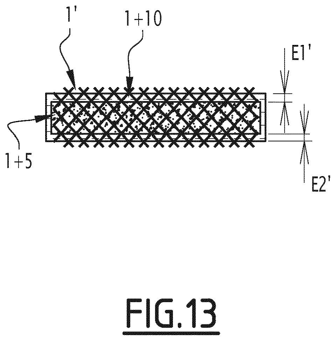

Après extraction du bain 6, on obtient un matériau composite comprenant des portions superficielles 1' de BN(C) dénuées de matériau protecteur et de polymère d'épaisseur E1 et E2 respectives, une couche interne de MCP 5, encapsulées au sein d'une couche d'enrobage de polymère 10 d'épaisseur E' (figure 13).

De façon alternative, le composant obtenu à la Figure 6 peut être réalisé selon le deuxième ou troisième mode de réalisation selon l'invention.

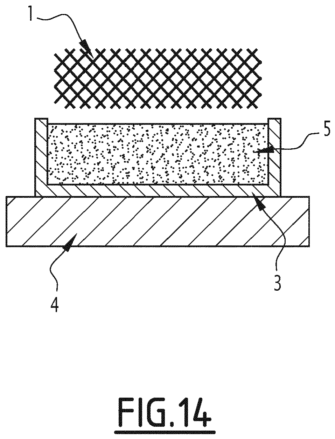

Comme illustré sur les figures 14 à 16, selon le deuxième mode de réalisation du procédé selon l'invention, le matériau composite selon l'invention peut être préparé par préparation intermédiaire de la couche interne (5) gravure sélective de MCP.

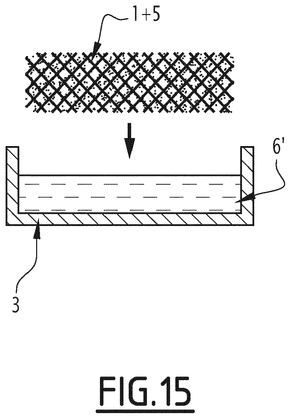

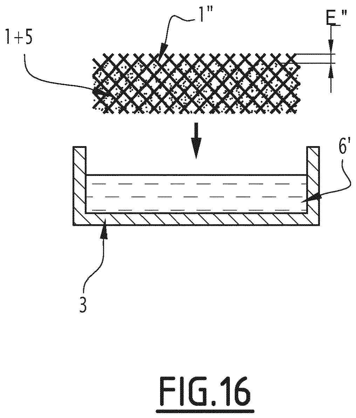

La fabrication du composite comprend tout d'abord l'immersion de la structure continue de BN(C) dans un bain de MCP 5 contenu dans un récipient 3 placé sur une plaque chauffante 4. L'immersion est réalisée en totalité selon le deuxième mode de réalisation (Figure 14). Puis le matériau est extrait du bain : il est alors constitué de la structure de BN(C) imprégnée sur toute son épaisseur de MCP 5. Les portions superficielles du matériau ainsi obtenu sont alors trempées dans un bain d'une solution de gravure 6', permettant de dissoudre le MCP sur les portions immergées d'épaisseur E" (Figures 15 et 16). Les faces inférieures et supérieures peuvent ainsi être immergées successivement, pour dégager deux portions superficielles 1" inférieures et supérieures de BN(C) dénuées de MCP. Selon une variante de ce mode de réalisation, le matériau peut être complètement immergé, ceci aboutissant à ce que toutes les portions superficielles soient dégagées de MCP, sous toutes les faces du matériau.

Un troisième mode de réalisation peut être représenté en combinant les étapes des Figures 1-5 et 14-16.

Le matériau composite ainsi formé peut ensuite être appliqué sur un composant à réguler thermiquement, par exemple un composant électronique.

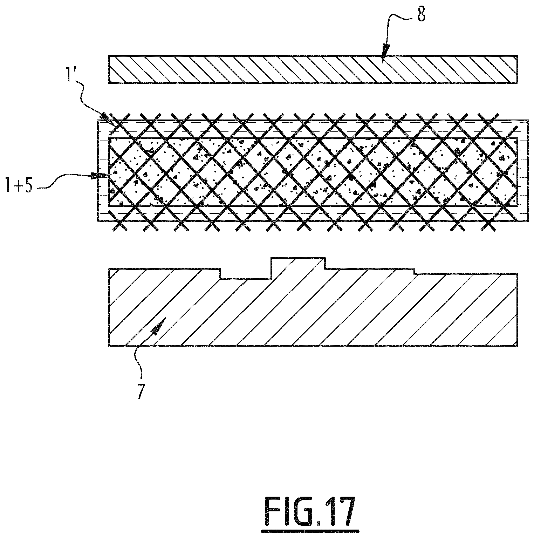

Selon une variante représentée à la Figure 17, le matériau composite est encapsulé entre un capot d'aluminium 8 et un composant électronique 7, tel que par exemple un processeur.

Le composant 7 présente un relief irrégulier en surface. Par compression, les portions superficielles 1' du matériau composite comblent les cavités et épousent les rugosités du composant 7.

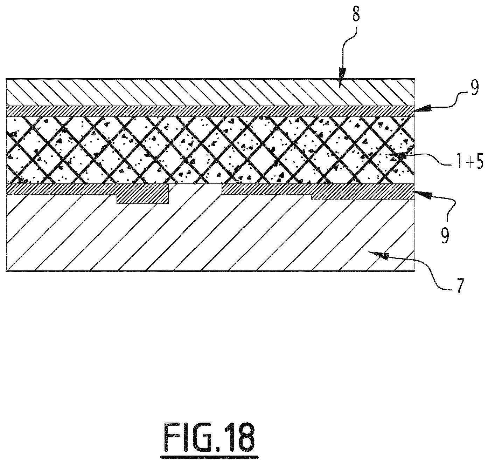

Ainsi, comme illustré la Figure 18, les portions superficielles 1' comprimées forment des couches 9 de BN(C) qui sont en contact avec le composant 7 d'une part et le capot 8 d'autre part. Ceci assure une isolation électrique, la passivation du composant et la réduction de la résistance thermique de contact.

Les exemples suivants illustrent la présente invention de façon non limitative.

### Exemple 1 : Préparation de la mousse de BN(C)

Une mousse de BN a été préparée par application de la méthodologie décrite par Loeblein et al., Small, vol.10, n.15, 2992-2999, 2014, sans réaliser l'étape de croissance du carbone. Du PMMA est déposé juste avant la gravure du nickel afin de renforcer mécaniquement le BN. Le PMMA peut être retiré ou conservé après gravure du Nickel.

### Exemple 2 : préparation du composite

### Stratégie

Pour réaliser la mousse de BNC infusée par le MCP (Matériau à changement de phase) uniquement en son centre et pas en surface, la première stratégie est d'utiliser un matériau qui va protéger les surfaces de la mousse pendant l'infusion. Ce matériau protecteur sera ensuite retiré.

### Protection des faces de la mousse

Le PEO (Polyéthylène Oxyde) a été utilisé à titre de matériau protecteur. Dans un premier temps, celui-ci est dilué dans de l'eau dans des proportions qui permettent d'obtenir un polymère avec une viscosité adéquate, ici entre 20 et 25% de PEO.

En deuxième étape, le polymère dilué est entreposé sous vide à environ 2.5 mTorr pendant 30 min. Le but de cette étape de « dégazage », est de retirer les bulles d'air qui ont été piégées dans le polymère pendant le mélange. Sans cette étape, pendant la phase de densification des bulles d'air pourraient se former, endommager la mousse et compromettre l'uniformité de l'épaisseur du polymère.

Troisième étape, le polymère est déposé dans un moule en aluminium. La quantité de polymère va dépendre des dimensions du moule, afin d'avoir une épaisseur de polymère d'environ 3 mm. Ensuite la mousse est déposée sur le polymère qui va légèrement le pénétrer. La profondeur de pénétration va dépendre de la viscosité du polymère. Enfin, le moule est déposé sur une plaque chauffante, afin de densifier le polymère en évaporant le solvant (ici l'eau) de façon progressive. Il a été établit expérimentalement qu'une étape de 80 °C pendant 40 min puis une élévation de 5 °C toute les 5 min pour atteindre 120 °C est favorable. Toutefois, ces températures et temps dépendent de la sonde de température de la plaque chauffante ainsi que de l'environnement du laboratoire car tout est fait sous air.

Quatrième étape, la mousse avec une face protégée est retirée du moule. Une des faces est perforée à l'aide d'une aiguille. Ces perforations ont pour but d'aider à l'infusion du MCP par la suite et n'endommagent que très peu la mousse.

La cinquième étape est identique à la troisième mais sur la face opposée de la mousse.

### L'infusion du MCP dans la mousse protégée

La paraffine a été utilisée à titre de MCP.

La paraffine est chauffée à 110 °C, c'est-à-dire légèrement au-dessus de la température de fusion de 90 °C de la paraffine, dans le moule en aluminium. Une fois la paraffine en phase liquide, la mousse avec les deux faces protégées y est plongée : la paraffine s'infiltre sur les côtés mais aussi par la face perforée qui est gardée au-dessus. La mousse reste entre 3 et 5 min dans le MCP pour s'assurer que l'infusion soit complète, tout en évitant la fusion du polymère de protection. Enfin celui-ci est mis à refroidir, naturellement ou dans un frigidaire pour accélérer le refroidissement.

### Le retrait du polymère de protection

Pour retirer le polymère, on plonge la mousse protégée dans de l'eau à température ambiante. Le composé est maintenu à la verticale (pour ne pas endommager les surfaces) dans un bécher d'eau pendant une nuit. On renouvelle le bain d'eau et on laisse agir pendant une nuit supplémentaire pour améliorer la déprotection en fonction de l'épaisseur du polymère ainsi que de la taille de l'échantillon et la quantité d'eau. Enfin, l'échantillon est mis à sécher.

### Exemple 3 : caractérisations/performance du composite

Caractérisations thermiques :
- Mesure de la densité du composé final. Afin de montrer que la mousse ne modifie que très peu le poids du MCP seul.
- Mesure de l'énergie latente de fusion du composé. Pour la même raison, qui est de montrer le faible impact de la mousse sur la capacité de stockage thermique du MCP. On cherche à conserver l'énergie latente de fusion du MCP.
- Mesure de la conductivité thermique afin de montrer l'apport et l'intérêt de la mousse.
- Mesure de résistance de contact pour vérifier la capacité du composé à se conformer aux surfaces.

Caractérisations électriques
- Evaluer la conductivité électrique du composé pour confirmer son aspect isolant pour le BN(C) pure, et légèrement conducteur pour le BN(C)C. De même pour la validation des zones isolantes ou légèrement conductrices dans le cas d'un dopage localisé.
- Mesures Radiofréquences (pertes, transmissions) pour connaitre l'impact de la présence du composé dans un environnement électronique.

Caractérisations physiques
- Coefficient d'expansion thermique du composé pour le futur design du packaging.
- Résistance mécanique en compression et tension
- Visualisation de la conformabilité de la mousse libérée en surface.

### Exemple 4 : Préparation du composite avec matériau de protection et par gravure incluant la réalisation d'une encapsulation en PDMS.

Afin d'éviter des fuites du MCP pendant la phase de fusion de celui-ci, ce procédé propose d'inclure un matériau de packaging.

La structure continue de BN(C) est tout d'abord infusée partiellement sur une épaisseur d'environ 5 mm par du NPG en phase liquide à 130°C, étapes a) et b). Le procédé peut être répété sur la face opposée, étape c). Une fois le NPG refroidi et solidifié, le MCP est infusé dans la partie libre de la structure continue. L'infusion se fait à 120°C dans sur plaque chauffante ou dans un four, étape d). Le composé obtenu est alors plongé dans une solution de gravure rapide pour le NPG et lente pour le MCP, typiquement de l'éthanol à 60°C, étape e). Le NPG est alors dissous presque instantanément et le MCP est gravé lentement. Le composé avec une portion superficielle de 5 mm est retiré de la solution de gravure, puis une phase de protection d'une partie de la portion superficielle est réitérée suivant la technique de protection superficielle vue précédemment. Toutefois, la protection est réalisée de façon à conserver une partie de la portion superficielle non infusée entre la protection et le MCP, étapes f), g) et h).

L'étape suivante consiste à préparer le matériau de packaging, typiquement du PDMS, le mélangeant à un agent de solidification avec un ratio de 10:1 , et en le plaçant sous-vide pendant 1h pour le dégazage. Une fois le PDMS prêt, celui-ci est placé dans un moule dans lequel est plongé le composé, étape h). Le tout est remis sous-vide pendant 1h pour retirer d'éventuelle bulles issues de l'étape d'immersion, puis l'ensemble est placé dans un four à 80°C pour solidification du PDMS pendant 1h, étape i). Après solidification du PDMS celui-ci est découpé en surface pour ne faire apparaitre que le matériau de protection, le NPG solide, étape j).

Enfin, le NPG est retiré en plongeant l'ensemble dans un bain d'éthanol à 60°C pendant quelques minutes afin de dissoudre le NPG, étape k). Il en résulte un MCP scellé par du PDMS avec une structure continue traversant l'ensemble du composé , étape l), assurant la conduction thermique et la réduction de la résistance de contact thermique.

En option, il est possible pendant le procédé d'avoir une étape de gravure plus longue lors de l'étape e), permettant d'avoir une portion superficielle sur les autres faces du composé. La suite du procédé est identique. Cela permet la présence de la structure continue dans le PDMS. En effet, la présence de la structure continue dans le PDMS permet d'augmenter sa conductivité thermique et donc de le rendre conducteur de chaleur.

La réalisation de cette option, permet d'avoir un packaging isolant thermiquement ou conducteur, ainsi que isolant électriquement ou conducteur suivant le type de structure continue utilisée.

### Exemple 5 : fabrication d'un composant comprenant le composite

L'invention peut être appliquée dans le cas d'un transistor de puissance, dissipant par exemple 20 W, lors d'une utilisation cyclique, par exemple pour un fonctionnement continu inférieur à 15 min, avec 15 min de refroidissement. Le MCP est choisi en fonction de la température maximale critique du transistor : la température de fusion du MCP doit être égale ou inférieure à celle de la température critique du transistor. Le matériau selon l'invention est appliqué directement sur le transistor, avec une des faces dénudée du MCP en contact avec le transistor pour assurer le bon contact thermique. Une encapsulation est réalisée autour du MCP ainsi qu'à la base du processeur pour assurer l'étanchéité.

## Revendications

1. Matériau composite comprenant :
- Du nitrure de bore (BN(C)) sous forme d'un matériau poreux constitué de BN éventuellement dopé au carbone (BNC) de structure 3D continue, non dispersée;
- Une couche interne d'un matériau à changement de phase (MCP) (5) incorporé au sein de ladite structure continue de BN(C) (1) et
- Une portion superficielle (1') de BN(C) dénuée de MCP, sous chacune des faces externes supérieure et inférieure du matériau composite, d'épaisseur E1 et E2,
ledit matériau étant **caractérisé en ce que** :
la couche de MCP (5) est encapsulée par une couche d'enrobage de polymère (10) d'épaisseur E', et lesdites portions superficielles (1') dénuées de MCP sont situées chacune de part et d'autre de la couche interne de MCP encapsulée.

2. Matériau selon la revendication 1 tel que ledit polymère est du polydiméthylsiloxane (PDMS).

3. Matériau composite selon la revendication 1 ou 2, tel que la structure continue de BN(C) est une mousse de BN(C).

4. Matériau composite selon l'une quelconque des revendications précédentes, tel que la structure continue de BN(C) (1) est une mousse continue de BNC.

5. Procédé de préparation du matériau composite selon l'une quelconque des revendications précédentes, ledit procédé comprenant :
i. la formation d'une couche interne de MCP (5) au sein de la structure continue de BN(C) (1) comprenant deux zones superficielles inférieure et supérieure (1") d'épaisseurs respectives E1" et E2" dénuées de MCP par une stratégie de protection/déprotection des couches superficielles et/ou par une stratégie de gravure sélective du MCP;
ii. l'encapsulation de la couche de MCP (5) par une couche d'enrobage polymérique (10) d'épaisseur E'.

6. Procédé selon la revendication 5 tel que la formation de la couche interne par protection/déprotection comprend les étapes suivantes :
- La protection préalable de chaque portion superficielle sous les faces externes inférieure et supérieure de la structure continue de BN(C) sur l' épaisseur E1" et E2", respectivement ;
- L'imprégnation de la structure continue de BN(C) par un MCP sous forme liquide ;
- La déprotection sélective des portions superficielles (1") protégées ;
d'où il résulte une structure continue de BN(C) dans laquelle est incorporée une couche interne de MCP (5), à l'exception desdites portions superficielles (1") d'épaisseur E1" et E2", dénuées de MCP.

7. Procédé selon la revendication 5 tel que la formation (i) de la couche interne (5) par gravure sélective du MCP comprend les étapes suivantes :
- L'imprégnation de la structure continue de BN(C) (1) par un MCP (5) sous forme liquide ;
- La gravure sélective du MCP au sein d'au moins portion superficielle (1').

8. Procédé selon la revendication 5 tel que la formation (i) de la couche interne de MCP (5) comprend :
- La protection préalable d'au moins une portion superficielle (1') de la structure continue de BN(C) (1) par un matériau protecteur ayant une vitesse de gravure différente que celle du MCP ;
- L'imprégnation de la structure continue de BN(C) (1) par un MCP (5) sous forme liquide ; et
- La gravure du MCP par immersion de la ou des zones superficielles imprégnées (1') du matériau dans un solvant de gravure.

9. Procédé selon la revendication 5 tel que l'encapsulation ii) comprend les étapes suivantes :
- La protection partielle de chaque portion superficielle (1") sous chaque face inférieure et supérieure d'un matériau composite obtenu à l'étape (i), sur une épaisseur E1 et E2 respectivement inférieure à E1" et E2", d'où il résulte deux portions superficielles (1');
- L'imprégnation du matériau composite ainsi protégé sur chacune de ces deux portions superficielles (1') par le polymère d'enrobage (10) sous forme liquide ;
- La déprotection sélective des portions protégées (1');
formant ainsi une structure continue de BN(C) dans laquelle est incorporée une couche interne de MCP (5) encapsulée par un polymère (10) d'épaisseur E', ladite couche interne 5 encapsulée étant située entre deux portions superficielles (1') de BN(C) dénuées de MCP d'épaisseur E1 et E2.

10. Composant électronique (7) comprenant un matériau composite selon l'une quelconque des revendications 1 à 4.

11. Procédé de fabrication du composant électronique (7) selon la revendication 10 comprenant l'étape d'application du composite selon l'une quelconque des revendications 1-4 sur un composant.

## Patentansprüche

1. Verbundmaterial, umfassend:
- Bornitrid (BN(C)) in Form eines porösen Materials, das aus BN besteht, das gegebenenfalls mit Kohlenstoff dotiert (BNC) ist, mit kontinuierlicher, nicht dispergierter 3D-Struktur;
- eine innere Schicht aus einem Phasenwechselmaterial (PCM) (5), die in die kontinuierliche Struktur aus BN(C) (1) eingebettet ist, und
- einen Oberflächenabschnitt (1') aus BN(C) frei von MCP unter jeder der oberen und unteren Außenseite des Verbundmaterials mit einer Stärke E1 und E2,
wobei das Material **dadurch gekennzeichnet ist, dass**:
die MCP-Schicht (5) durch eine Polymerumhüllungsschicht (10) mit Stärke E' eingekapselt ist, und sich die MCP-freien Oberflächenabschnitte (1') jeweils auf beiden Seiten der eingekapselten inneren MCP-Schicht befinden.

2. Material nach Anspruch 1, wobei das Polymer Polydimethylsiloxan (PDMS) ist.

3. Verbundmaterial nach Anspruch 1 oder 2, wobei die kontinuierliche BN(C)-Struktur ein BN(C)-Schaumstoff ist.

4. Verbundmaterial nach einem der vorherigen Ansprüche, wobei die kontinuierliche BN(C)-Struktur (1) ein kontinuierlicher BNC-Schaumstoff ist.

5. Verfahren zur Herstellung des Verbundmaterials nach einem der vorherigen Ansprüche, das Verfahren umfassend:
i. Bilden einer inneren MCP-Schicht (5) innerhalb der kontinuierlichen BN(C)-Struktur (1), umfassend zwei untere und obere Oberflächenbereiche (1") mit jeweiligen Stärken E1" und E2" frei von MCP durch eine Strategie zum Schützen/Entschützen der Oberflächenschichten und/oder durch eine Strategie zum selektiven Ätzen des MCP;
ii. Einkapseln der MCP-Schicht (5) mit einer polymeren Umhüllungsschicht (10) mit Stärke E'.

6. Verfahren nach Anspruch 5, wobei die Bildung der inneren Schicht durch Schützen/Entschützen die folgenden Schritte umfasst:
- vorheriges Schützen von jedem Oberflächenabschnitt unter der unteren und oberen Außenseite der kontinuierlichen BN(C)-Struktur auf der Stärke E1" bzw. E2";
- imprägnieren der kontinuierlichen BN(C)-Struktur mit einem MCP in flüssiger Form;
- selektives Entschützen der geschützten Oberflächenabschnitte (1");
woraus eine kontinuierliche BN(C)-Struktur resultiert, in die eine innere Schicht aus MCP (5) eingebettet ist, mit Ausnahme der Oberflächenabschnitte (1") mit Stärke E1" und E2", die frei von MCP sind.

7. Verfahren nach Anspruch 5, wobei die Bildung (i) der inneren Schicht (5) durch selektives Ätzen des MCP die folgenden Schritte umfasst:
- Imprägnieren der kontinuierlichen BN(C)-Struktur (1) mit einem MCP (5) in flüssiger Form;
- selektives Ätzen des MCP innerhalb des mindestens einen Oberflächenabschnitts (1').

8. Verfahren nach Anspruch 5, wobei die Bildung (i) der inneren MCP-Schicht (5) Folgendes umfasst:
- vorheriges Schützen mindestens eines Oberflächenabschnitts (1') der kontinuierlichen BN(C)-Struktur (1) mit einem Schutzmaterial, das eine andere Ätzgeschwindigkeit aufweist als MCP;
- Imprägnieren der kontinuierlichen BN(C)-Struktur (1) mit einem MCP (5) in flüssiger Form; und
- Ätzen des MCP durch Eintauchen des imprägnierten Oberflächenbereichs oder der imprägnierten Oberflächenbereiche (1') des Materials in ein Ätzlösungsmittel.

9. Verfahren nach Anspruch 5, wobei das Einkapseln ii) die folgenden Schritte umfasst:
- teilweises Schützen von jedem Oberflächenabschnitt (1") unter jeder Unter- und Oberseite eines in Schritt (i) erlangten Verbundmaterials auf eineer Stärke E1 und E2, die jeweils kleiner als E1" und E2" ist, woraus zwei Oberflächenabschnitte (1') resultieren;
- Imprägnieren des so geschützten Verbundmaterials an jedem dieser zwei Oberflächenabschnitte (1') mit dem Umhüllungspolymer (10) in flüssiger Form;
- selektives Entschützen der geschützten Abschnitte (1');
wodurch eine kontinuierliche BN(C)-Struktur gebildet wird, in die eine innere MCP-Schicht (5) eingebettet ist, die von einem Polymer (10) mit der Dicke E' eingekapselt ist, wobei sich die eingekapselte innere Schicht 5 zwischen zwei MCP-freien Oberflächenabschnitten (1') von BN(C) mit Stärke E1 und E2 befindet.

10. Elektronische Komponente (7), umfassend ein Verbundmaterial nach einem der Ansprüche 1 bis 4.

11. Verfahren zur Herstellung der elektronischen Komponente (7) nach Anspruch 10, umfassend den Schritt eines Aufbringens des Verbundstoffs nach einem der Ansprüche 1-4 auf eine Komponente.

## Claims

1. Composite material comprising:
- Boron nitride (BN(C)) in the form of a porous material consisting of BN possibly doped with carbon (BNC) of continuous 3D structure, not dispersed;
- An internal layer of a Phase Change Material (PCM) (5) incorporated within said continuous structure of BN(C) (1), and
- A surface portion (1') of BN(C) devoid of PCM, under each of the upper and lower external faces of the composite material, with thickness E1 and E2,
said material being **characterized in that**:
the layer of PCM (5) is encapsulated by a coating layer of polymer (10) of thickness E', and said surface portions (1') devoid of PCM, are each located on either side of the internal layer of encapsulated PCM.

2. Material according to claim 1 such that said polymer is polydimethylsiloxane (PDMS).

3. Composite material according to claim 1 or 2, such that the continuous structure of BN(C) is a foam of BN(C).

4. Composite material according to any one of the preceding claims, such that the continuous structure of BN(C) (1) is a continuous foam of BNC.

5. Method for preparing the composite material according to any one of the preceding claims, said method comprising:
i. the formation of an internal layer of PCM (5) within the continuous structure of BN(C) (1) comprising two lower and upper surface areas (1") of respective thickness E1" and E2" free of PCM by a strategy of protection/deprotection of the surface layers and/or by a strategy of selective etching of PCM;
ii. encapsulating the PCM layer (5) with a polymer coating layer (10) of thickness E'.

6. Method according to claim 5, such that the formation of the internal layer by protection/deprotection comprises the following steps:
- The prior protection of each surface portion under the lower and upper external faces of the continuous structure of BN(C) over the thickness E1" and E2", respectively;
- The impregnation of the continuous structure of BN(C) with a PCM in liquid form;
- Selective deprotection of the protected surface portions (1"); from which results a continuous structure of BN(C) in which is incorporated an internal layer of PCM (5), with the exception of said surface portions (1") of thickness E1" and E2", stripped of PCM.

7. Method according to claim 5 wherein the formation of the internal layer (5) by selective etching of the PCM comprises the following steps:
- The impregnation of the continuous structure of BN(C) (1) with a PCM (5) in liquid form;
- Selective etching of the PCM within at least one surface portion (1').

8. Method according to claim 5 wherein the formation of the internal layer (5) comprises:
- The prior protection of at least a surface portion (1') of the continuous structure of BN(C) (1) with a protective material having a different etching speed than that of PCM;
- The impregnation of the continuous structure of BN(C) (1) with a PCM (5) in liquid form; and
- The etching of the PCM by immersion of the impregnated surface area (s) (1') of the material in an etching solvent.

9. Method according to claim 5 wherein the encapsulating ii) comprises the following steps:
- Partial protection of each surface portion (1") under each lower and upper face of a composite material obtained in step (i), over a thickness E1 and E2 that are respectively less than E1" and E2", resulting in two superficial portions (1');
- The impregnation of the composite material thus protected on each of these two surface portions (1') by the coating polymer (10) in liquid form;
- Selective deprotection of the protected portions (1');
thus forming a continuous BN structure (C) in which is incorporated an internal layer of PCM (5) encapsulated by a polymer (10) of thickness E', said internal encapsulated layer 5 being situated between two surface portions (1') of BN(C) devoid of PCM of thickness E1 and E2.

10. Electronic component (7) comprising a composite material according to any one of claims 1 to 4.

11. Method for manufacturing the electronic component (7) according to claim 10 comprising the step of applying the composite according to anyone of claims 1-4 to a component.
